# EUROPÄISCHE PATENTANMELDUNG

(11) **EP 0 779 656 A2**
(43) Veröffentlichungstag der Anmeldung: **18.06.1997**
(21) Anmeldenummer: 96118514.7
(22) Anmeldetag: 15.11.1996
(51) Int. Cl.: H01L 21/8242

(54) **Verfahren zur Herstellung von Kondensatoren in einer Halbleiteranordnung**

(30) Priorität: 15.12.1995 DE 19546999
(71) Anmelder: SIEMENS AKTIENGESELLSCHAFT, 80333 München (DE)
(72) Erfinder: Stengl, Reinhard, Dr., 86391 Stadtbergen (DE); Franosch, Martin, 81739 München (DE); Wendt, Hermann, Dr., 85630 Grasbrunn (DE)

(57) **Zusammenfassung**

Zur Herstellung von Kondensatoren, insbesondere für eine dyamische Speicherzellenanordnung mit Stapelkondensatoren, wird eine Schichtenfolge erzeugt, die alternierend Schichten aus einem ersten leitfähigen Material und aus einem zweiten dazu selektiv ätzbaren Material enthält. Aus der Schichtenfolge werden Schichtstrukturen gebildet, deren Flanken jeweils mit einer leitfähigen Stützstruktur (5) versehen werden. In den Schichtstrukturen werden Öffnungen, insbesondere Spalten gebildet, in denen die Oberfläche der Schichten freiliegt. Die Schichten aus dem zweiten Material werden selektiv zu den Schichten aus dem ersten Material entfernt. Die freiliegende Oberfläche der Schichten aus dem ersten Material (4₁) und der Stützstruktur (5) werden mit einem Kondensatordielektrikum (6) versehen, auf das eine Gegenelektrode (7) aufgebracht wird. Der Kondensator ist unter Einsatz von zu p⁺-dotiertem Polysilizium selektivem Ätzen von p⁻-dotiertem Polysilizium herstellbar.

## Beschreibung

Für verschiedene integrierte Schaltungstypen, wie zum Beispiel dynamische Speicherzellenanordnungen, Analog Digital- und Digital Analog-Wandler sowie Filterschaltungen, werden Kondensatoren auf Halbleiterbasis benötigt. Bei der Herstellung von Kondensatoren auf Halbleiterbasis ist im Hinblick auf eine erhöhte Integrationsdichte oder reduzierte Chipfläche das Problem zu lösen, den Platzbedarf des Kondensators bei gleichbleibender Kapazität zu reduzieren.

Dieses Problem ist besonders gravierend bei dynamischen Halbleiterspeichern, bei denen die benötigte Fläche der im allgemeinen verwendeten Eintransistorspeicherzelle von Speichergeneration zu Speichergeneration mit zunehmender Speicherdichte reduziert wird. Gleichzeitig muß eine gewisse Mindestkapazität des Speicherkondensators erhalten bleiben.

Eine Eintransistorspeicherzelle einer dynamischen Halbleiterspeicheranordnung (DRAM-Speicheranordnung) umfaßt einen Auslesetransistor und einen Kondensator. In dem Kondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden. Zur sicheren Speicherung der Ladung und gleichzeitigen Unterscheidbarkeit der ausgelesenen Information muß der Kondensator eine Mindestkapazität aufweisen. Die untere Grenze für die Kapazität des Speicherkondensators wird derzeit bei 25 fF gesehen.

Bis zum 1MBit-Generation wurden sowohl der Auslesetransistor als auch der Kondensator als planare Bauelemente realisiert. Ab der 4MBit-Speichergeneration wurde eine weitere Flächenreduzierung der Speicherzelle durch eine dreidimensionale Anordnung von Auslesetransistor und Speicherkondensator erzielt. Eine Möglichkeit dafür besteht darin, den Speicherkondensator in einem Graben zu realisieren (siehe zum Beispiel K. Yamada et al, Proc. Intern. Electronic Devices and Materials IEDM 85, Seite 702 ff). Die Elektroden des Speicherkondensators sind in diesem Fall entlang der Oberfläche des Grabens angeordnet. Dadurch wird die effektive Fläche des Speicherkondensators, von der die Kapazität abhängt, gegenüber dem Platzbedarf an der Oberfläche des Substrats für den Speicherkondensator, der dem Querschnitt des Grabens entspricht, vergrößert.

Eine weitere Möglichkeit, zur Vergrößerung der Speicherkapazität bei gleichbleibendem oder verringertem Platzbedarf des Speicherkondensators besteht darin, den Speicherkondensator als Stapelkondensator, den sogenannten stacked capacitor, auszuführen. Dabei wird über den Wortleitungen eine Struktur aus Polysilizium, zum Beispiel eine Kronenstruktur oder ein Zylinder, gebildet, die mit dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist. Für den Speicherkondensator wird der freie Raum oberhalb der Substratoberfläche genutzt. Dabei kann die gesamte Zellfläche von der Polysiliziumstruktur überdeckt sein, solange die Polysiliziumstrukturen zu benachbarten Speicherzellen gegeneinander isoliert sind.

Aus EP 0 415 530 B1 ist eine Speicherzellenanordnung mit einem Stapelkondensator als Speicherkondensator bekannt. Der Stapelkondensator umfaßt eine Polysiliziumstruktur mit mehreren, im wesentlichen parallel übereinander angeordneten Polysiliziumschichten, die über mindestens eine seitliche Stütze miteinander verbunden sind. Diese kühlrippenartig angeordneten Schichten führen zu einer deutlichen Vergrößerung der Oberfläche der Polysiliziumstruktur gegenüber der Projektion der Polysiliziumstruktur auf die Substratoberfläche. Die Polysiliziumstruktur wird durch alternierende Abscheidung von Polysiliziumschichten und selektiv dazu ätzbaren SiO₂-Schichten auf der Oberfläche des Substrats, Strukturierung dieser Schichten, Erzeugung von Flankenbedeckungen (Spacer aus Polysilizium) an mindestens einer Flanke der Schichtstruktur und selektives Herausätzen der SiO₂-Schichten gebildet. Die Polysiliziumstrukturen sind dabei arsendotiert. Anschließend wird durch thermische Oxidation Siliziumoxid als Kondensatordielektrikum gebildet, auf dem eine Zellplatte aus dotiertem Polysilizium abgeschieden wird.

Der Erfindung liegt das Problem zugrunde, ein Verfahren zur Herstellung von Kondensatoren für eine Halbleiteranordnung, insbesondere für eine DRAM-Anordnung anzugeben, mit dem eine erhöhte Packungsdichte bei einem gegenüber den bekannten Lösungen reduziertem Prozeßaufwand erzielt wird.

Dieses Problem wird erfindungsgemäß gelöst durch ein Verfahren gemäß Anspruch 1. Weitere Ausgestaltungen der Erfindung gehen aus den übrigen Ansprüchen hervor. In dem erfindungsgemäßen Verfahren wird auf einem Substrat eine Schichtenfolge erzeugt, die jeweils alternierend eine Schicht aus einem ersten Material und eine Schicht aus einem zweiten Material umfaßt. Das erste Material ist elektrisch leitfähig. Das zweite Material ist selektiv zum ersten Material ätzbar. Die Schichtfolge wird so strukturiert, daß mindestens eine Schichtstruktur mit bis auf das Substrat reichenden Flanken entsteht. Es wird eine Stützstruktur aus leitfähigem Material gebildet, die mindestens die Flanken der Schichtstruktur bedeckt. In der Schichtstruktur wird anschließend mindestens eine Öffnung gebildet, in der die Oberfläche der Schichten aus dem ersten und aus dem zweiten Material freiliegt. Anschließend werden die Schichten aus dem zweiten Material selektiv zu den Schichten aus dem ersten Material und der Stützstruktur entfernt. Die freiliegende Oberfläche der Schichten aus dem ersten Material und der Stützstruktur wird mit einem Kondensatordielektrikum versehen. An der Oberfläche des Kondensatordielektrikums wird eine Gegenelektrode gebildet.

Die Stützstruktur ist beim Herausätzen der Schichten aus dem zweiten Material an mindestens drei Flanken der Schichtstruktur angeordnet. Dadurch wird eine hohe mechanische Stabilität gewährleistet, durch die ein Zusammenkleben der Schichten aus dem ersten Material beim Herausätzen der Schichten aus dem zweiten Material vermieden wird. Da diese mechanische Stabilität durch die Stützstruktur gewährleistet ist, kann die Schichtdicke der Schichten aus dem ersten Material unabhängig von mechanischen Stabilitätsanforderungen an die Schichten aus dem ersten Material gewählt werden. Die Schichten aus dem ersten Material können insbesondere im Dickenbereich zwischen 20 bis 50 nm und 20 bis 50 nm realisiert werden. Dadurch wird auch die Gesamthöhe des Kondensators bei gleichbleibender Kapazität reduziert.

Vorzugsweise werden die Schichten aus dem ersten Material und die Stützstruktur aus p⁺-dotiertem Silizium mit einer Dotierstoffkonzentration > 10²⁰ cm⁻³ und die Schichten aus dem zweiten Material aus p⁻-dotiertem Silizium mit einer Dotierstoffkonzentration < 10¹⁹ cm⁻³ gebildet. Aus H. Seidel et al, J. Electrochem. Soc. Vol. 137 (1990) Seite 3626 ff ist bekannt, daß p⁻-dotiertes Silizium selektiv zu p⁺-dotiertem Silizium ätzbar ist. Zwischen Silizium mit einer Bordotierung > 10²⁰ cm⁻³ und Silizium mit einer Bordotierung < 10¹⁹ cm⁻³ werden Ätzratenunterschiede bis zu einem Faktor 1000 erzielt.

P⁺-dotiertes Silizium und p⁻-dotiertes Silizium können in demselben Reaktor abgeschieden werden. Dadurch kann die Schichtenfolge ohne Anlagenwechsel nur durch Umschalten der Prozeßparameter realisiert werden. Dieses bedeutet eine deutliche Prozeßvereinfachung.

Die Stützstruktur aus dotiertem Silizium kann durch selektive Epitaxie von dotiertem Silizium oder durch in situ dotierte Abscheidung und anisotropes Rückätzen einer dotierten Polysiliziumschicht gebildet werden. Beide Alternativen sind im Temperaturbereich unter 800°C durchfuhrbar, so daß ein Ineinanderdiffundieren der Schichten aus p⁺-dotiertem Silizium und p⁻-dotiertem Silizium vermieden wird.

Die Stützstruktur wird in beiden Fällen mit definierten Oberflächen an den Flanken der Schichtstruktur gebildet. Dadurch wird sichergestellt, daß die Schichten aus dem zweiten Material gleichmäßig zwischen den Schichten aus dem ersten Material herausgeätzt werden. Auf diese Weise wird verhindert, daß die Schichten aus dem zweiten Material lokal noch nicht herausgeätzt sind und gleichzeitig an anderen Stellen die Stützflächen schon so stark angegriffen werden, daß einzelne Schichten aus dem ersten Material herunterfallen.

Vorzugsweise werden bei der Bildung der Öffnung in der Schichtstruktur die Schichtstruktur und die Stützstruktur in zwei Teilbereiche geteilt, die durch einen bis auf die Oberfläche des Substrats reichenden Spalt beabstandet sind. Aus den beiden Teilbereichen werden zwei Kondensatoren gebildet. Der Abstand und die Strukturgröße der Teilbereiche können dabei jeweils entsprechend der minimalen Strukturgröße F in der jeweiligen Technologie gebildet werden. Dadurch wird eine hohe Packungsdichte erzielt.

Bei Herstellung des Kondensators als Speicherkondensator für eine dynamische Speicherzellenanordnung erfolgt die Herstellung des Kondensators vorzugsweise als Stapelkondensator. In diesem Fall umfaßt das Substrat ein Halbleitersubstrat mit Auswahltransistoren, Bitleitungen, Wortleitungen und einer isolierenden Schicht, auf deren Oberfläche die Schichtenfolge aufgebracht wird. Vorzugsweise wird die isolierende Schicht planarisiert, so daß die Schichtenfolge auf einer im wesentlichen planaren Oberfläche gebildet wird.

Im folgenden wird die Erfindung anhand der Figuren und der Ausführungsbeispiele näher erläutert.
- Figur 1: zeigt ein Substrat mit einer Schichtenfolge, die alternierend Schichten aus einem ersten Material und Schichten aus einem zweiten Material umfaßt.
- Figur 2: zeigt das Substrat mit Schichtstrukturen.
- Figur 3: zeigt das Substrat nach Bildung einer Stützstruktur, die die Flanken der Schichtstruktur bedeckt.
- Figur 4: zeigt das Substrat nach Bildung einer Öffnung in den Schichtstrukturen und selektivem Herausätzen von Schichten aus dem zweiten Material.
- Figur 5: zeigt das Substrat nach Bildung eines Kondensatordielektrikums und einer Gegenelektrode.
- Figur 6: zeigt den in Figur 5 mit VI-VI bezeichneten Schnitt durch das Substrat.
- Figur 7: zeigt ein Substrat mit einer Schichtenfolge, die alternierend Schichten aus einem ersten Material und Schichten aus einem zweiten Material umfaßt.
- Figur 8: zeigt das Substrat nach Bildung von Schichtstrukturen aus der Schichtenfolge.
- Figur 9: zeigt das Substrat nach Abscheidung einer die Schichtstrukturen bedeckenden Schicht.
- Figur 10: zeigt das Substrat nach anisotropem Rückätzen der Schicht zur Bildung von Stützstrukturen.
- Figur 11: zeigt das Substrat nach Bildung von Öffnungen in den Schichtstrukturen und selektivem Herausätzen der Schichten aus dem zweiten Material.
- Figur 12: zeigt das Substrat nach Bildung eines Kondensatordielektrikums und einer Gegenelektrode.
- Figur 13: zeigt ein Layout, bei dem die Schichtstrukturen versetzt angeordnet sind.
- Figur 14: zeigt ein Layout, bei dem die Schichtstrukturen rasterförmig angeordnet sind.

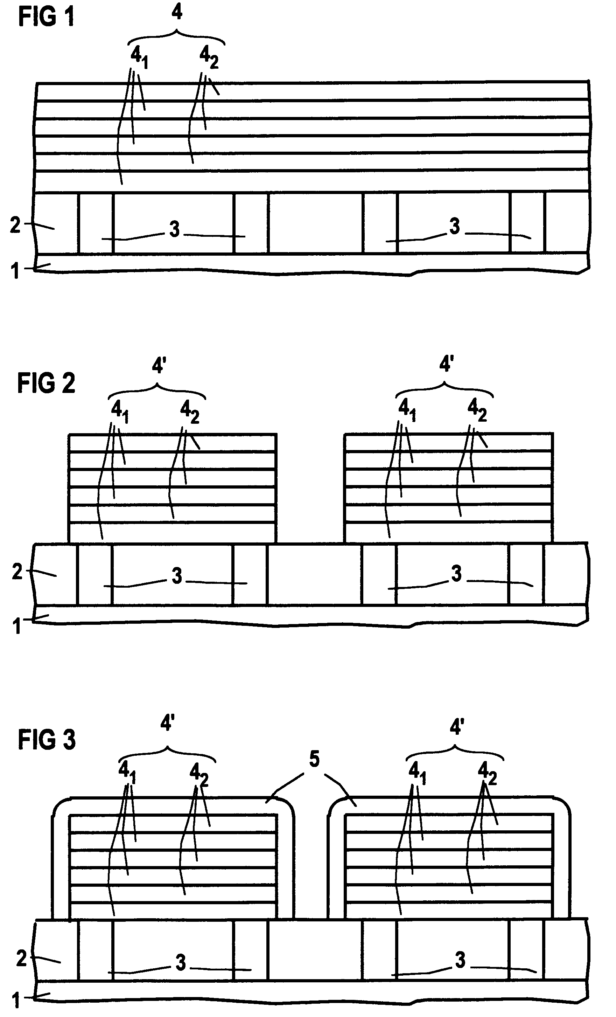

Auf ein Substrat 1 wird eine isolierende Schicht 2 aufgebracht. Das Substrat 1 ist zum Beispiel ein Halbleitersubstrat, insbesondere eine monokristalline Siliziumscheibe, das Auswahltransistoren mit Wortleitungen und Bitleitungen umfaßt. Die isolierende Schicht wird zum Beispiel aus SiO₂ gebildet und mit Hilfe von Planarisierungsverfahren planarisiert (siehe Figur 1). In der isolierenden Schicht 2 werden Kontaktlöcher 3 geöffnet und mit elektrisch leitfähigem Material, zum Beispiel dotiertes Polysilizium, Wolfram, Tantal, Titan, Titannitrid oder Wolframsilizid aufgefüllt. Die Kontaktlöcher 3 werden so angeordnet, daß sie jeweils auf ein Source/Drain-Gebiet eines der Auswahltransistoren im Substrat 1 reichen.

Auf die Oberfläche der isolierenden Schicht 2 wird eine Schichtenfolge 4 aufgebracht, die jeweils alternierend p⁺-dotierte Polysiliziumschichten 4₁ und p⁻-dotierte Polysiliziumschichten 4₂ umfaßt. Die p⁺-dotierten Polysiliziumschichten 4₁ weisen eine Dotierstoffkonzentration von zum Beispiel 5 x 10²⁰ cm⁻³ auf. Die p⁻-dotierten Schichten 4₂ weisen eine Dotierstoffkonzentration von zum Beispiel 1 x 10¹⁹ cm⁻³ auf. Die p⁺-dotierten Polysiliziumschichten 4₁ und die p⁻-dotierten Polysiliziumschichten 4₂ werden in einer Schichtdicke von jeweils 20 nm zum Beispiel durch CVD abgeschieden.

Die oberste Schicht der Schichtenfolge ist eine p⁻-dotierte Polysiliumschicht 4₂.

Anschließend werden aus der Schichtenfolge 4 durch anisotropes Ätzen unter Verwendung einer Maske Schichtstrukturen 4' gebildet. Zwischen den Schichtstrukturen 4' liegt die Oberfläche der isolierenden Schicht 2 frei (siehe Figur 2). Das anisotrope Ätzen erfolgt zum Beispiel mit CF₄ und SF₆.

Anschließend wird mittels selektiver Epitaxie von Silizium eine Stützstruktur 5 gebildet (siehe Figur 3). Die selektive Epitaxie wird in einem Prozeß unter Verwendung von SiCl₂H₂, Hcl, H₂, B₂H₆ als Prozeßgas im Temperaturbereich zwischen 700 und 750°C durchgeführt. Die Prozeßtemperatur wird in diesem niedrigen Temperaturbereich gewählt, um ein Ineinanderdiffundieren der p⁺-dotierten Polysiliziumschichten 4₁ und p⁻-dotierten Polysiliziumschichten 4₂ zu vermeiden. Bei der selektiven Epitaxie wächst die Stützstruktur 5 in situ p⁺-dotiert auf der Oberfläche der Schichtstrukturen 4' auf. Auf der Oberfläche der isolierenden Schicht 2 wächst dagegen kein Silizium auf. Die Stützstruktur 5 bedeckt die Flanken und die Oberfläche der Schichtstrukturen 4' vollständig.

Anschließend werden die Schichtstrukturen 4' mit der sie bedeckenden Stützstruktur 5 unter Verwendung einer photolithographisch erzeugten Maske durch anisotropes Ätzen zum Beispiel mit CF₄ und SF₆ so strukturiert, daß jeweils zwei Teilbereiche entstehen. Die beiden Teilbereiche sind jeweils durch einen Spalt voneinander getrennt. Im Bereich des Spaltes weisen die Teilbereiche jeweils eine Flanke auf, an der die Oberfläche der p⁻-dotierten Schichten 4₂ und der p⁺-dotierten Schichten 4₁ freiliegt.

Durch eine zu p⁺-dotiertem Polysilizium und SiO₂ selektive Ätzung werden anschließend die verbleibenden Teile der p⁻-dotierten Polysiliziumschichten 4₂ entfernt. Die selektive Ätzung erfolgt zum Beispiel in einer alkalischen Ätzlösung, die Ethylendiamin, Brenzcatechin, Pyrazin und Wasser enthält. Vorzugsweise liegt die Konzentration der Lösung in folgendem Bereich: 1 Liter Ethylendiamin, 160 gr Brenzcatechin, 6 gr Pyrazin und 133 ml Wasser. Darüber hinaus kann als Ätzlösung auch KOH verwendet werden mit Konzentrationen im Bereich von 10 bis 50 Gewichtsprozent. Diese Ätzung weist in Bezug auf p⁺-dotiertes Polysilizium und p⁻-dotiertes Polysilizium eine Selektivität von mindestens 1:500 auf.

Die p⁺-dotierten Schichten 4₁ und die Stützstruktur 5, die von der selektiven Ätzung nicht angegriffen werden, sind mechanisch und elektrisch miteinander verbunden.

Die Oberfläche der p⁺-dotierten Schichten 4₁ und der Stützstruktur 5 wird mit einem Kondensatordielektrikum 6 versehen. Das Kondensatordielektrikum 6 wird zum Beispiel aus einer Dreifachschicht aus SiO₂, Si₃N₄ und SiO₂ in einer oxidäquivalenten Dicke von 4 nm gebildet.

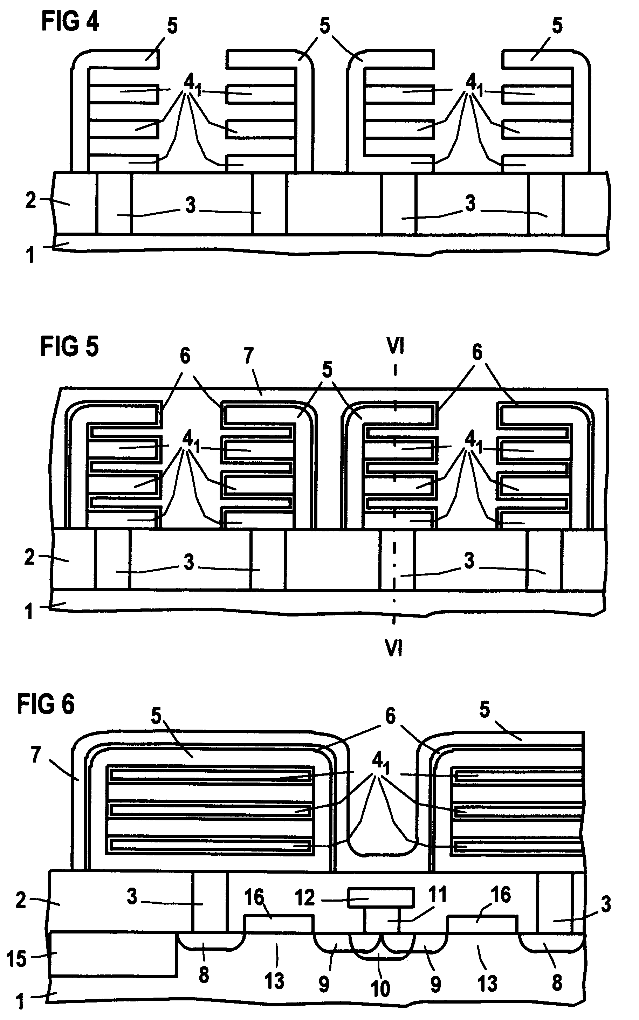

Durch Abscheidung einer in situ p⁺-dotierten Polysiliziumschicht wird anschließend eine Gegenelektrode 7 gebildet (siehe Figur 5 und Figur 6).

In dem in Figur 6 dargestellten Schnitt sind im Substrat 1 Auswahltransistoren angedeutet. Die p⁺-dotierten Schichten 4₁ und die damit verbundene Stützstruktur 5 bilden jeweils einen Speicherknoten für einen Speicherkondensator. Dieser Speicherknoten ist über den darunter angeordneten Kontakt 3 mit einem Source/Drain-Gebiet 8 eines Auswahltransistors verbunden. Das andere Source/Drain-Gebiet 9 des Auswahltransistors ist über ein Anschlußgebiet 10 mit dem entsprechenden Source/Drain-Gebiet 9 des benachbarten Auswahltransistors verbunden. Das Anschlußgebiet 10 ist ferner über einen vergrabenen Bitleitungskontakt 11 mit einer vergrabenen Bitleitung 12 verbunden. Die vergrabene Bitleitung 12 und der Bitleitungskontakt 11 sind durch die isolierende Schicht 2 umgeben. Zwischen den Source/Drain-Gebieten 8 und 9 eines Auswahltransistors sind das Kanalgebiet 13, ein Gatedielektrikum (nicht dargestellt) und eine als Wortleitung 14 wirkende Gateelektrode angeordnet. Die Wortleitung 14 und der Bitleitungskontakt 11 sind jeweils aus dotiertem Polysilizium gebildet. Die Bitleitung 12 wird aus dotiertem Polysilizium, Wolframsilizid oder Wolfram gebildet. Auf der der Bitleitung 12 abgewandten Seite des Source/Drain-Gebietes 8 ist jeweils eine Isolationsstruktur, zum Beispiel ein flacher, mit isolierendem Material gefüllter Graben 15 (Shallow trench isolation) zur Isolation zwischen benachbarten Auswahltransistorpaaren vorgesehen.

In einem zweiten Ausführungsbeispiel wird auf ein Substrat 21 ein isolierende Schicht 22 aufgebracht. Das Substrat 21 besteht zum Beispiel aus einer monokristallinen Siliziumscheibe, die mehrere Auswahltransistoren, Wortleitungen und Bitleitungen umfaßt. Die isolierende Schicht 22 wird zum Beispiel aus SiO₂ gebildet. In einem Planarisierungsverfahren, zum Beispiel durch chemisch mechanisches Polieren oder durch Planarisierungsätzen, wird die Oberfläche der isolierenden Schicht 22 planarisiert. In der isolierenden Schicht 22 werden Kontaktlöcher 23 geöffnet, die jeweils auf ein Source/Drain-Gebiet eines der Auswahltransistoren im Substrat 21 reichen. Die Kontaktlöcher 3 werden mit leitfähigem Material, zum Beispiel Wolfram, Tantal, Titan oder Titannitrid aufgefüllt.

Auf die Oberfläche der isolierenden Schicht 22 wird eine Schichtenfolge 24 aufgebracht, die alternierend p⁺-dotierte Polysiliziumschichten 24₁ und p⁻-dotierte Polysiliziumschichten 24₂ umfaßt. Die p⁺-dotierten Polysiliziumschichten 24₁ und die p⁻-dotierten Polysiliziumschichten 24₂ weisen dabei jeweils eine Dicke von 20 nm auf. Die p⁺-dotierten Polysiliziumschichten 24₁ und die p⁻-dotierten Polysiliziumschichten 24₂ werden jeweils durch in situ dotierte Abscheidung in einem CVD-Verfahren abgeschieden. Auf der Oberfläche der isolierenden Schicht 22 ist dabei eine der p⁺-dotierten Polysiliziumschichten 24₁ angeordnet. Die oberste der Schichtenfolge 24 wird ebenfalls durch eine der p⁺-dotierten Polysiliziumschichten 24₁ gebildet.

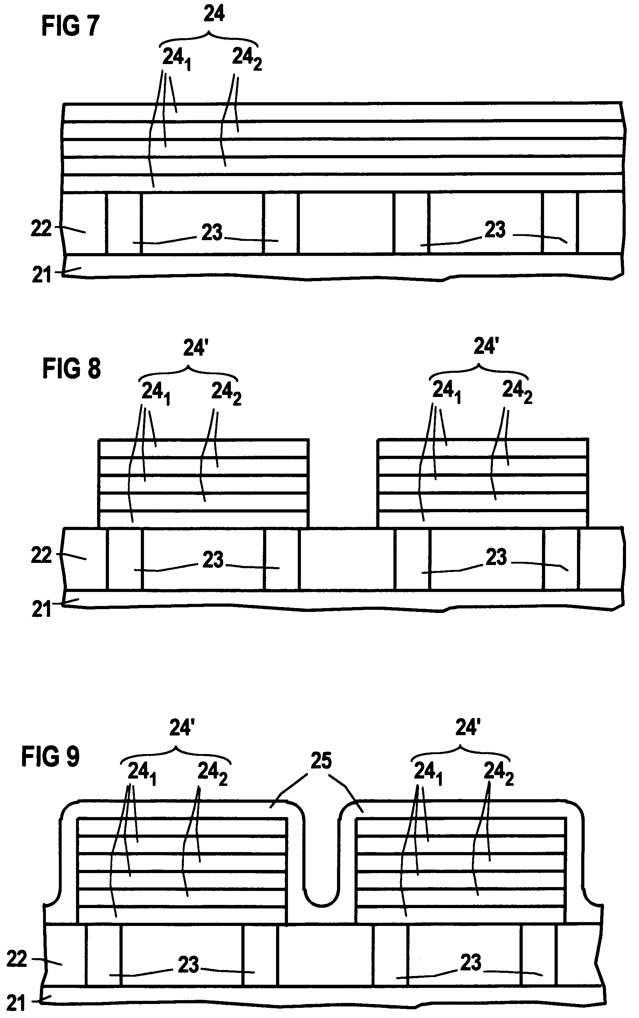

Aus der Schichtenfolge 24 werden durch anisotropes Ätzen zum Beispiel CF₄ und SF₆ Schichtstrukturen 24' gebildet. Außerhalb der Schichtstrukturen 24' wird die Oberfläche der isolierenden Schicht 22 freigelegt (siehe Figur 8).

Anschließend wird durch in situ dotierte CVD-Abscheidung eine weitere p⁺-dotierte polykristalline Siliziumschicht 25 abgeschieden. Die p⁺-dotierte polykristalline Siliziumschicht 25 weist eine Dicke von zum Beispiel 30 bis 50 nm auf. Sie weist eine im wesentlichen konforme Kantenbedeckung auf (siehe Figur 9).

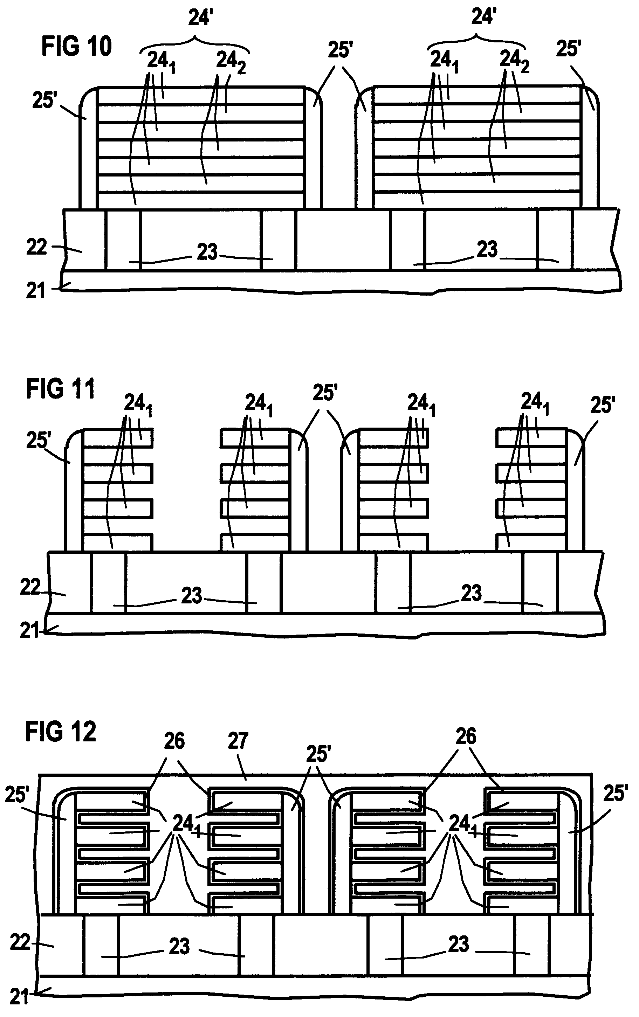

Durch anisotropes Rückätzen mit zum Beispiel CF₄ und SF₆ werden aus der weiteren p⁺-dotierten polykristallinen Siliziumschicht 25 Stützstrukturen 25' gebildet. Die Stützstrukturen 25' bedecken die Flanken der Schichtstrukturen 24' (siehe Figur 10). Bei der Bildung der Stützstrukturen 25' wird die Oberfläche der isolierenden Schicht 22 außerhalb der Stützstrukturen 25' und der Schichtstrukturen 24' freigelegt.

Unter Verwendung einer photolithographisch erzeugten Maske werden die Schichtstrukturen 24' durch anisotropes Ätzen zum Beispiel mit CF₄ und SF₆ in jeweils zwei Teilbereiche strukturiert. Die beiden Teilbereiche sind durch eine Spalte voneinander getrennt, wobei im Bereich der Spalte die Oberfläche der isolierenden Schicht 22 freigelegt ist. In Richtung der Spalte weisen die Teilbereiche jeweils eine Flanke auf, an der die Oberflächen der p⁻-dotierten Polysiliziumschichten 24₂ und der p⁺-dotierten Polysiliziumschichten 24₁ freiliegen.

Durch eine zu p⁺-dotiertem Polysilizium und zu SiO₂ selektive Ätzung werden anschließend die verbleibenden Teile der p⁻-dotierten Polysiliziumschichten 24₂ entfernt. Die selektive Ätzung erfolgt zum Beispiel in einer alkalischen Ätzlösung, die Ethylendiamin, Brenzcatechin, Pyrazin und Wasser enthält. Vorzugsweise liegt die Konzentration der Lösung in folgendem Bereich: 1 l Ethylendiamin, 160 gr Brenzcatechin, 6 gr Pyrazin und 133 ml Wasser. Darüber hinaus kann auch KOH als Ätzlösung dienen mit Konzentrationen im Bereich von 10 bis 50 Gewichtsprozent.

Diese Ätzung weist in Bezug auf p⁺-dotiertes Polysilizium und p⁻-dotiertes Polysilizium eine Selektivität von mindestens 1:500 auf. Daher werden bei dieser Ätzung weder die verbleibenden Teile der p⁺-dotierten Polysiliziumschichten 24₁ noch die Stützstrukturen 25' angegriffen (siehe Figur 11). Die p⁺-dotierten Polysiliziumschichten 24₁ sind mit der jeweiligen Stützstruktur 25' mechanisch und elektrisch verbunden.

Die Oberfläche der Stützstrukturen 25' und der p⁺-dotierten Polysiliziumschichten 24₁ werden mit einem Kondensatordielektrikum 26 versehen. Das Kondensatordielektrikum 26 umfaßt zum Beispiel eine Dreifachschicht aus SiO₂, Si₃N₄ und SiO₂ (sogenanntes ONO), die eine oxidäquivalente Dicke von 4 nm aufweist. Durch Abscheidung einer leitfähigen Schicht wird abschließend eine Gegenelektrode 27 gebildet. Die Gegenelektrode 27 wird zum Beispiel in situ dotierte Abscheidung von p⁺-dotiertem Polysilizium gebildet. Dabei werden die Zwischenräume zwischen benachbarten p⁺-dotierten Polysiliziumschichten 24₁ mit dem Material der Gegenelektrode 27 aufgefüllt (siehe Figur 12). Mit einer Stützstruktur 25' zusammenhängende p⁺-dotierte Polysiliziumschichten 24₁ bilden jeweils einen Speicherknoten. Die Anordnung der Auswahltransistoren und der Schnitt durch die Speicherkondensatoren senkrecht zur Zeichenebene in Figur 12 entspricht der Anordnung und dem Schnitt in Figur 6.

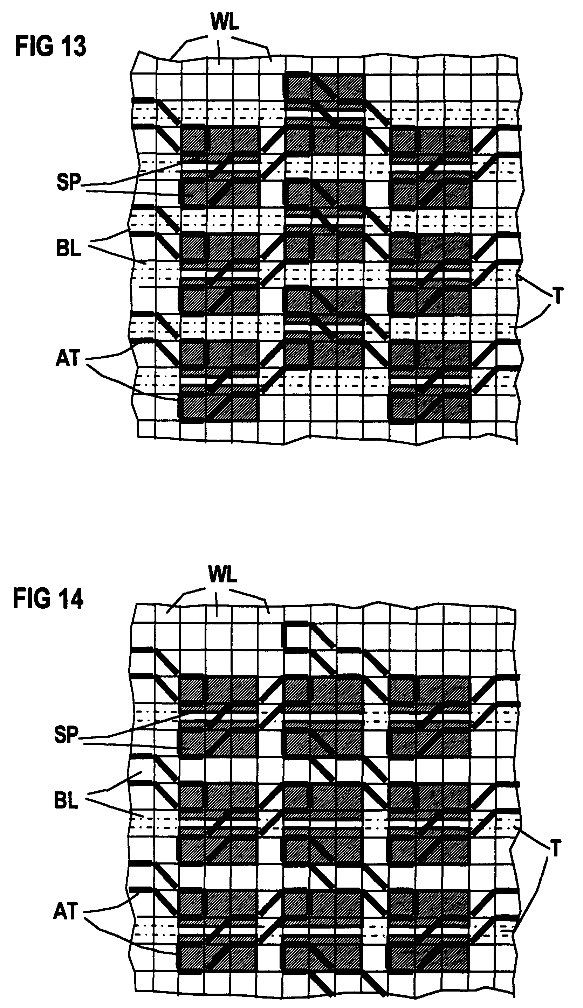

In Figur 13 ist ein Layout für eine dynamische Speicherzellenanordnung mit nach dem erfindungsgemäßen Verfahren hergestellten Speicherkondensatoren dargestellt. In der Speicherzellenanordnung verlaufen senkrecht zueinander Wortleitungen WL und Bitleitungen BL. Die Speicherkondensatoren SP sind als schraffierte Rechtecke eingezeichnet. Die Lage der Auswahltransistorpaare AT ist jeweils als fettgestrichelte Konturlinie eingetragen. Bei der Herstellung werden jeweils zwei Speicherkondensatoren aus einer Schichtstruktur 4' bzw. 24' gebildet. In dem Layout in Figur 13 sind als strichpunktierte Linien T die Trennspalten der Maske eingetragen, mit der die Schichtstrukturen 4' bzw. 24' in die Teilbereiche, die in ihrer Form der Form der Speicherkondensatoren SP entsprechen, aufgetrennt werden. Die Schichtstrukturen 4' bzw. 24' sind in diesem Layout in Spalten angeordnet, wobei benachbarte Spalten um den halben Abstand zwischen den Mittelpunkten benachbarten Schichtstrukturen 4', 24' gegeneinander versetzt angeordnet sind.

Zur Erzielung einer möglichst hohen Packungsdichte ist es vorteilhaft, die Schichtstrukturen mit quadratischem Querschnitt und einer Seitenlänge von 3 F, wobei F die in der jeweiligen Technologie minimale herstellbare Strukturgröße ist, zu bilden. Der Abstand zwischen benachbarten Schichtstrukturen 4', 24' beträgt F. Dann betragen auch die Breiten und Abstände der Wortleitungen WL und Bitleitungen BL jeweils F. Eine Speicherzelle hat in diesem Fall einen Flächenbedarf von 8 F². Um bei einer Strukturgröße F von 0,18 µm, wie sie in der 1GBit-Generation vorgesehen ist, die für die dynamische Speicherzellenanordnung erforderliche Mindestkapazität von 25 fF zu erzielen, sind 12 p⁺-dotierte Polysiliziumschichten 4₁ bzw. 24₁ erforderlich. Bei einer Schichtdicke der p⁺-dotierten Polysiliziumschichten 4₁ bzw. 24₁ und der p⁻-dotierten Polysiliziumschichten 4₂ bzw. 24₂ von 20 nm ergibt sich dabei eine Stapelhohe von etwa 0,4 µm.

In Figur 14 ist ein weiteres Layout für eine dynamische Speicherzellenanordnung mit einem nach dem erfindungsgemäßen Verfahren hergestellten Speicherkondensatoren dargestellt. Neben den Wortleitungen WL, Bitleitungen BL, Speicherkondensatoren SP, Auswahltransistorpaaren AT sind wiederum die Trennspalten T dargestellt. Dieses Layout unterscheidet sich von dem in Figur 14 dargestellten Layout dadurch, daß die Schichtstrukturen 4', 24', aus denen durch Auftrennen die Teilbereiche für die Speicherkondensatoren SP gebildet werden, rasterförmig angeordnet sind. Benachbarte Spalten sind dabei nicht gegeneinander versetzt angeordnet. Der Abstand benachbarter Trennspalten T ist in diesem Layout doppelt so groß als in dem in Figur 13 dargestellten Layout. Dafür hat das in Figur 13 dargestellte Layout gegenüber dem in Figur 14 dargestellten Layout den Vorteil, daß an der Auflösungsgrenze eine entspanntere Lithographie vorliegt. Dieses wird mit feineren Strukturen in der Trennmaske erkauft.

Vorzugsweise werden die Trennspalten T in der Trennmaske unter Verwendung eines sogenannten CARL-Lack gebildet. Bei diesen Lacken wird durch eine chemische Nachbehandlung die Breite der Strukturgrößen verändert, so daß die Trennspalte T eine geringere Weite als die minimal herstellbare Strukturgröße F in der jeweiligen Technologie aufweisen.

## Patentansprüche

1. Verfahren zur Herstellung von Kondensatoren für eine Halbleiteranordnung,
- eine Schichtenfolge (4) erzeugt wird, die jeweils alternierend eine Schicht aus einem ersten Material (4₁) und eine Schicht aus einem zweiten Material (4₂) umfaßt, wobei das erste Material elektrisch leitfähig ist und das zweite Material selektiv zum ersten Material ätzbar ist,
- bei dem die Schichtenfolge (4) so strukturiert wird, daß mindestens eine Schichtstruktur (4') mit Flanken entsteht,
- bei dem eine Stützstruktur (5) aus leitfähigem Material gebildet wird, die mindestens die Flanken der Schichtstruktur (4') bedeckt,
- bei dem in der Schichtstruktur mindestens eine Öffnung gebildet wird, in der die Oberfläche der Schichten (4₁, 4₂) aus dem ersten und dem zweiten Material freiliegt,
- bei dem die Schichten aus dem zweiten Material (4₂) selektiv zu den Schichten aus dem ersten Material (4₁) und der Stützstruktur (5) entfernt werden,
- bei dem die freiliegende Oberfläche der Schichten aus dem ersten Material (4₁) und der Stützstruktur (5) mit einem Kondensatordielektrikum (6) versehen werden,
- bei dem an der Oberfläche des Kondensatordielektrikums (6) eine Gateelektrode (7) gebildet wird.

2. Verfahren nach Anspruch 1,
bei dem die Schichten aus dem ersten Material (4₁) und die Stützstruktur (5) aus p⁺-dotiertem Silizium mit einer Dotierstoffkonzentration > 10²⁰ cm⁻³ und die Schichten aus dem zweiten Material (4₂) aus p⁻-dotiertem Silizium mit einer Dotierstoffkonzentration < 10¹⁹ cm⁻³ gebildet werden.

3. Verfahren nach Anspruch 2,
- bei dem die Schichten aus dem ersten Material (4₁) und die Schichten aus dem zweiten Material (4₂) durch in situ dotierte Abscheidung von Polysilizium gebildet werden,
- bei dem die Stützstruktur (5) durch selektive Epitaxie von dotiertem Silizium gebildet wird.

4. Verfahren nach Anspruch 3,
bei dem die selektive Epitaxie unter Verwendung von SiCl₂H₂, HCl, H₂, B₂H₆ im Temperaturbereich zwischen 700 und 750° durchgeführt wird.

5. Verfahren nach Anspruch 2,
- bei dem die Schichten aus dem ersten Material (24₁) und die Schichten aus dem zweiten Material (24₂) durch in situ dotierte Abscheidung von Polysilizium gebildet werden,
- bei dem die Stützstruktur (25') durch in situ dotierte Abscheidung und anisotropes Rückätzen einer dotierten Polysiliziumschicht (25) gebildet wird.

6. Verfahren nach einem der Ansprüche 1 bis 5,
bei dem bei der Bildung der Öffnung in der Schichtstruktur (4') die Schichtstruktur mit der Stützstruktur (5) in zwei Teilbereiche geteilt wird, die durch einen Spalt beabstandet sind.

7. Verfahren nach einem der Ansprüche 1 bis 6,
bei dem das Substrat (1) ein Halbleitersubstrat mit Auswahltransistoren (AT), Bitleitungen (BL), Wortleitungen (WL) und einer isolierenden Schicht (2) umfaßt, auf deren Oberfläche die Schichtenfolge (4) aufgebracht wird.
